# EUROPEAN PATENT SPECIFICATION

(11) **EP 2 302 695 B1**
(45) Date of publication and mention of the grant of the patent: **22.08.2012**
(21) Application number: 10182002.5
(22) Date of filing: 29.09.2010
(51) Int. Cl.: H01L 31/048, C23C 14/10, B32B 7/12, C09J 175/04, B32B 27/36

(54) **Gas barrier composite, back sheet for solar cell module and solar cell module**
Gasbarriere-Verbundwerkstoff, rückseitige Folie für Solarzellenmodul und Solarzellenmodul
Composite formant barrière au gaz, feuille support pour module de cellule solaire et module de cellule solaire

(30) Priority: 29.09.2009 JP 2009225252
(43) Date of publication of application: 30.03.2011
(73) Proprietor: FUJIFILM Corporation, Tokyo 106-0031 (JP)
(72) Inventor: Iwanaga, Hiroshi, Kanagawa 258-8577 (JP)
(74) Representative: HOFFMANN EITLE

(56) References cited:
- J. GREENER ET AL.: "Moisture Permeability through Multilayered Barrier Films as applied to Flexible OLED Display", J. APPL. POLYM. SCI., vol. 106, 28 August 2007 (2007-08-28), pages 3534-3542, XP002613428, DOI: 10.1002/app.26863
- DATABASE WPI Week 200851 Thomson Scientific, London, GB; AN 2008-H99815 XP002613448, -& JP 2008 130647 A (TOPPAN PRINTING CO LTD) 5 June 2008 (2008-06-05)

## Description

### FIELD OF THE INVENTION

The invention relates to a gas barrier composite, a back sheet for a solar cell module, and a solar cell module using the back sheet.

### RELATED ART OF THE INVENTION

As clean energy source, attention is particularly focused on a solar cell which converts from solar light energy into electric energy using photovoltaic power. A back sheet for a solar cell module having a barrier property is investigated. For ensuring barrier property, aluminum foil has been disposed on a surface of a substrate film. However, ensuring of insulation has recently been demanded, and nonconductive material is desired to be used.

Under such a situation, JP-A-2008-130647 proposes a laminated-back sheet which is obtained by laminating two gas barrier films each having a substrate and a barrier layer which is obtained by disposing oxide on the substrate so as to face the barrier layers to each other. The back sheet in which such two gas barrier films are laminated to each other has a problem in that it cannot achieve sufficient barrier property if the barrier layer is thinner. On the other hand, J.Appl.Polym.Sci. Vol.106,3534-3542(2007) suggests that an adhesive layer having a thinner thickness between the gas barrier films to be laminated prevents water from invading from the cross-section direction of the gas barrier film, thereby achieving desired barrier property. However, in J.Appl.Polym.Sci. Vol.106,3534-3542(2007), it is impossible to reduce the thickness of the adhesive layer because the adhesion force degrades in reducing the thickness of the adhesive layer.

As mentioned above, the means has not actually been found that achieves desired barrier property and attains sufficient adhesion force. In particular, since solar cells are placed in outside and used over long years, it is important to ensure adhesive force for long years.

### SUMMARY OF THE INVENTION

As mentioned above, while it is effective to reduce the thickness of the adhesive layer so as to prevent water from invading from the cross-section direction of the gas barrier film, the adhesion force degrades when the thickness of the adhesive layer is thinner. An object of the invention is to solve the above problems, and to provide a back sheet for a solar cell which is obtained by laminating gas barrier films using adhesion, which achieves sufficient barrier property, and which does not reduce adhesion force between the gas barrier films when the thickness of the adhesive layer is thinner.

Under such situation, the inventor has investigated the means that does not degrade the adhesion force when the thickness of the adhesive layer is thinner. The inventor has earnestly investigated and found that the above problem can be solved by using a two-liquid type polyurethane adhesive as an adhesive and adjusting a surface roughness of the surfaces of gas barrier films which is to contact with the adhesive layer to a particular range. Thereby, the invention has been completed. Specifically, the aforementioned problem can be solved by the following means.
[1] A gas barrier composite as defined in appended Claim 1.
[2] The gas barrier composite according to [1] , wherein the adhesive layer has a thickness of from not less than 0.1 µm to less than 2 µm.
[3] The gas barrier composite according to [1] or [2], wherein the adhesive layer is adjacent to an inorganic layer of at least one of the gas barrier films.
[4] The gas barrier composite according to [1] or [2], wherein the adhesive layer is adjacent to an inorganic layer of at least one of the gas barrier films; and at least one of the gas barrier films comprises an undercoat layer between the substrate film and the inorganic layer.
[5] The gas barrier composite according to [1] or [2], wherein the adhesive layer is adjacent to the inorganic layers of the respective gas barrier films; and the gas barrier films each comprise an undercoat layer between the substrate film and the inorganic layer.
[6] The gas barrier composite according to any one of [1] to [5], wherein the two-liquid type polyurethane adhesive has a laminate strength of 1 N/15 mm or more and does not cause delamination after being placed at 105 °C at a relative humidity of 100% for 24 hours.
[7] The gas barrier composite according to any one of [1] to [6], wherein the two-liquid type polyurethane adhesive comprises an isocyanate compound comprising two or more functional groups and a polyurethane polyol.
[8] The gas barrier composite according to any one of [1] to [7], wherein the inorganic layers each are formed by deposition method.
[9] The gas barrier composite according to any one of [1] to [8], wherein the barrier layers each have an outermost layer having a surface roughness (Ra) of 0.1 to 1.0 nm.
[10] The gas barrier composite according to any one of [1] to [9], wherein the inorganic layers each have a thickness of 5 to 300 nm.
[11] The gas barrier composite according to any one of [1] to [10], wherein the substrate films each have a surface roughness (Ra) of 0.1 to 1.0 nm.
[12] The gas barrier composite according to any one of [1] to [11], wherein the barrier layers each comprise at least two inorganic layers and at least two organic layers laminated alternately.
[13] The gas barrier composite according to any one of [1] to [12], which comprises an undercoat layer between one of the substrate films and the inorganic layer; and wherein the undercoat layer has a surface roughness (Ra) of 2.0 nm or less.
[14] A back sheet for a solar cell module comprising the gas barrier composite of any one of [1] to [13].
[15] The back sheet for a solar cell module according to [14], wherein the two-liquid type polyurethane adhesive has a laminate strength of 1 N/15 mm or more and does not cause delamination after being placed at 105°C at a relative humidity of 100% for 24 hours.
[16] The back sheet for a solar cell module according to [14] or [15], wherein the two-liquid type polyurethane adhesive comprises an isocyanate compound comprising two or more functional groups and a polyurethane polyol.
[17] The back sheet for a solar cell module according to any one of [14] to [16], wherein the inorganic layers each are formed by deposition method.
[18] The back sheet for a solar cell module according to any one of [14] to [17], wherein the inorganic layers each comprise silicon oxide, aluminium oxide or a mixture thereof.
[19] The back sheet for a solar cell module according to any one of [14] to [18], wherein the barrier layers each have an outermost layer having a surface roughness (Ra) of 0.1 to 1.0 nm.
[20] A solar cell module comprising a back sheet for a solar cell module comprising the gas barrier composite of any one of [1] to [13] .

The invention makes it possible to maintain the adhesiveness of the gas barrier films even if the thickness of the adhesive layer is thinner. As a result, the invention makes it possible to provide a back sheet for a solar cell module excellent in barrier property and adhesiveness.

### BRIEF DESCRIPTION OF THE DRAWING

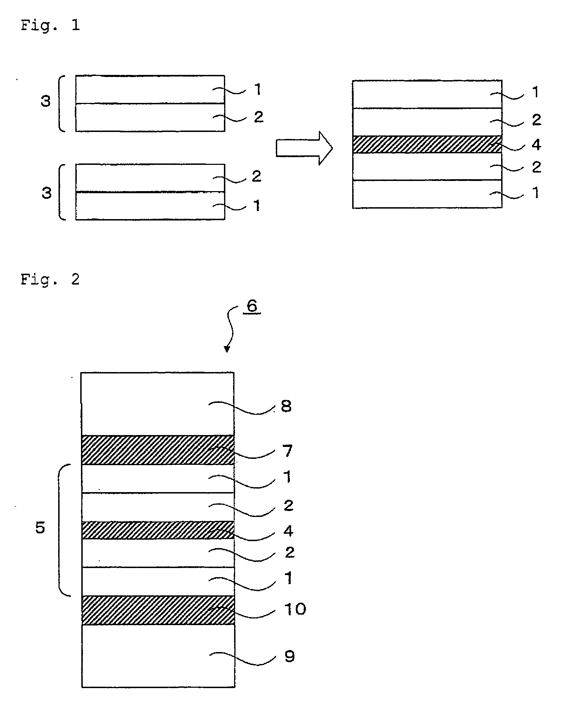

Fig. 1 is a diagrammatic illustration showing an example of a laminate structure of a gas barrier composite for use in a back sheet for a solar cell module of the invention comprises, wherein 1 stands for a substrate film, 2 stands for an inorganic layer, 3 stands for a gas barrier film, and 4 stands for an adhesive layer.

Fig. 2 is a diagrammatic illustration showing an example of a laminate structure of a back sheet for a solar cell module of the invention, wherein 1 stands for a substrate film, 2 stands for an inorganic layer, 4 stands for an adhesive layer, 5 stands for a gas barrier composite, 6 stands for a back sheet for a solar cell module, 7 stands for an adhesive layer, 8 stands for a basal plate, and 9 stands for a basal plate.

### DESCRIPTION OF SPECIFIC EMBODIMENTS

The contents of the invention are described in detail hereinunder. In this description, the numerical range expressed by the wording "a number to another number" means the range that falls between the former number indicating the lowermost limit of the range and the latter number indicating the uppermost limit thereof. "Organic EL device" as referred to herein means an organic electroluminescent device.

The back sheet for a solar cell module of the invention is characterized by comprising a gas barrier composite. The gas barrier composite comprises two gas barrier films and an adhesive layer between the gas barrier films, wherein the gas barrier films each have a substrate film and a barrier layer on the substrate film; the barrier layers each comprise an inorganic layer substantively compared of an inorganic oxide, an inorganic nitride or a mixture thereof; the barrier layers each have an outermost layer having a surface roughness (Ra) of 0.1 to 3nm; the barrier layers of the respective gas barrier films face to each other through the adhesive layer; and the adhesive layer is obtainable by curing a two-liquid type polyurethane adhesive.

Such a construction makes it possible to prevent water from invading from the cross-sectional direction of the gas barrier composite and to enhance the barrier property.

Fig. 1 shows an example of a gas barrier composite to be used for a back sheet for a solar cell module of the invention. The gas barrier films 3 comprises a substrate film 1 and an inorganic layer 2, which are stuck using an adhesion so that the inorganic layers 2 face to each other. In the embodiment, although each of the inorganic layers 2 contacts with the adhesive layer 4, the inorganic layers 2 each do not necessarily contact with the adhesive layer and may contact with a functional layer other. In the embodiment, while the barrier layer is composed of only one inorganic layer, the barrier layer may be composed of a plurality of layers. Examples of the layer composing the barrier layer include an undercoat layer which is mentioned later. The undercoat layers and the inorganic layers may be laminated alternately. In the invention, the layer which contacts with the adhesive layer is preferably an inorganic layer.

### <Surface Roughness of Outermost Surface of Barrier Layer (Ra)>

In the invention, the surface roughness (Ra) of the outermost surface of the barrier layer is 0.1 to 3 nm, preferably 0.1 to 1.0 nm. The outermost layer of the barrier layer is preferably an inorganic layer, of which the surface Ra can be achieved by employing a substrate film having a smoothness surface or by disposing an undercoat layer having a smoothness surface. Particularly, disposing an undercoat layer as a base layer of the inorganic layer is preferable from the viewpoint of handleability.

### <Undercoat Layer>

As mentioned above, the undercoat layer is employed for the main purpose of adjusting the outermost surface of an inorganic layer to have a particular Ra. The Ra of the undercoat layer is preferably 2.0 nm or less, more preferably 1.0 nm. The material to be used for the undercoat layer is preferably an organic material. Specifically, the undercoat layer may be obtained by coating polymer material or oligomer material which is soluble in an organic solvent. The undercoat layer may be formed by subjecting material such as polyfunctional acrylate and polyfunctional isocyanate to cross-linking reaction. The undercoat layer is preferably formed according to coating or deposition from the viewpoints of dimension stability, stability for material, and adhesiveness. It is more preferably formed according to coating because its productivity is high and its leveling effect is easily exerted. Another preferably applicable method is a film formation method comprising subjecting aqueous dispersed organic material (latex) to aqueous-coating, and then, drying and heat-sealing it.

### <Thickness of Adhesive Layer>

The thickness of the adhesive layer in the invention is preferably from not less than 0.1 µm to less than 2 µm, more preferably from 0.2µm to 1.5 µm, still more preferably from 0.5 µm to 1.0 µm. The invention employs a two-liquid type polyurethane adhesive so as to form an adhesive layer having a suitable thickness.

### <Kinds of Adhesion>

The adhesive layer in the invention is a layer obtained by curing a two-liquid type polyurethane adhesive. However, the adhesive layer in the invention may comprise another kind of adhesion and an additive and the like without diverting the scope of the invention. In general, the adhesive layer in the invention comprises cured product of the two-liquid type polyurethane adhesive in an amount of 95% by weight or more.

The two-liquid type polyurethane adhesive in the invention is preferably an hydrolysis resistant adhesion, which has a laminate strength of 1 N/15 mm and does not cause delamination, even after placed at 105°C at a relative humidity of 100 % for 24 hours. The two-liquid type polyurethane adhesive in the invention is preferably an adhesive comprising a polyether polyurethane polyol and an isocyanate comprising two or more functional groups.

Examples of the two-liquid type polyurethane adhesive in the invention include a cured type adhesion of polyester polyol and di-isocyanate and a cured type adhesion of polyether polyol and di-isocyanate. Polyester series adhesives are generally more excellent in strength and heat resistance than polyether series adhesives, and therefore, are frequently used for retort material. However, the inventor has surprisingly found that the gas barrier composite of the invention can attain sufficient adhesion if a polyether series adhesive is used. Especially, the gas barrier composite can attain sufficient adhesion when the gas barrier composite has a structure in which the inorganic layers are deposited and both of the inorganic layers adhere to each other through the adhesive layer. Further, it has been found that the adhesiveness tends to be effectively exerted by enhancing smoothness of the deposited inorganic layer.

### <Inorganic Layer>

The inorganic layer in the invention comprises an inorganic oxide, an inorganic nitride or a mixture thereof. The "comprise" herein means that the inorganic layer is substantively composed of only those component, and however, does not mean that minor component such as impurity is excluded. It is, for example, an inorganic layer which comprises inorganic oxide, inorganic nitride or a mixture thereof in an amount of 98% by weight or more. The inorganic layer preferably comprises one or two metal oxides, more preferably comprises aluminum oxide, silicon oxide, tin oxide, magnesium oxide, zinc oxide or a mixture thereof, further more preferably silicon oxide, aluminum oxide or a mixture thereof.

Silicon oxide is still more preferably silicon oxide represented by the formula SiOx, wherein x is 0.9 to 1. 5. Such an inorganic layer has not been used for an organic EL device and the like since it may be colored. However, the coloration causes a problem when it is used for a solar cell.

The inorganic layer in the invention can be formed by known-methods such as a vapor deposition method, for example physical vapor deposition (PVD) and chemical vapor deposition (CVD), or a liquid phase method, for example a method using sol-gel-method. Of those, preferred are vacuum vapor deposition method, sputtering method, ion plating method and CVD method. Deposition method is more preferable from the viewpoints of productivity and cost. Especially, by laminating the deposited inorganic layers through adhesive, the effect is achieved that the stable inorganic layer of which productivity is high at low cost is obtained.

The thickness of the inorganic layer varies for its preferable condition depending on kinds of material composing the inorganic layer, and it is generally 5 to 300 nm. When the thickness is less than 5 nm, the inorganic layer may not form a uniform film, and therefore, the barrier layer sometimes does not function properly. When the thickness of the inorganic layer is beyond 300 nm, flexibility of the thin film is sometimes not sufficiently attained, and therefore, the thin film is sometimes destroyed by external force such as bending or tension and does not function as a barrier layer. The thickness of the inorganic layer is preferably 10 nm to 150 nm, more preferably 20 nm to 100 nm.

### <Substrate Film>

The substrate film in the invention is not specifically limited and well-known films may be used for the substrate film. For example, the substrate film is preferably a film disclosed in JP-A-2009-196318, paragraphs 0046 to 0053.

Ra for the substrate film in the invention is preferably 0.1 to 10.0 nm, more preferably 0.1 to 5.0 nm.

The gas barrier composite in the invention may have another functional layer without diverting the scope of the invention. Such a functional layer may be a layer disclosed in JP-A-2009-196318, paragraph 0045.

### <Back Sheet for Solar Cell Module>

The embodiment in which the gas barrier composite of the invention is used for a back sheet for a solar cell module is exemplified. Fig. 2 is a diagrammatic illustration showing an example in which the gas barrier composite of the invention is applied to a back sheet for a solar cell module, wherein 5 stands for a gas barrier composite and 6 stands for a back sheet for a solar cell module. The upper side of the back sheet for a solar cell module 6 corresponds to the upper side of the solar cell, and the underside of the back sheet for a solar cell module 6 corresponds to the underside of the solar cell. In the embodiment, the substrate film 1 on the upper side of the gas barrier composite 5 is stuck to the basal plate 8 through the second adhesive layer 7. In the basal plate 8, white pigment may be added. Although the basal plate 8 is stuck to the substrate film 1 in the embodiment, the basal plate 8 and the second adhesive layer 7 may be omitted by increasing the thickness of the substrate film 1 and adding colorant to the substrate film 1. Thus, the embodiment in which the substrate film in the invention comprises colorant is preferably exemplified. On the other hand, the basal place 9 which is used on the position of the underside of a solar cell is preferably a film having weatherability, or a film adhered to a film comprising a resin having weatherability such as polyvinyl fluoride for the purpose of improving weatherability. The basal plate 9 is also stuck to the substrate film 1 through the third adhesive layer 10.

A solar cell device is provided between a back sheet for a solar cell module as mentioned above and a front sheet for a solar cell module. The solar cell devices preferably applicable to the back sheet of the invention are not specifically limited. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

The back sheet for a solar cell module of the invention is generally required to be placed for 2000 hours at 85°C at 85% relative humidity as promotion assessment, which is known to correspond to physical values after the back sheet for a solar cell module is placed for 168 hours at 105°C at a relative humidity of 100%. Therefore, the back sheet for a solar cell module preferably meets such a requirement.

### EXAMPLES

The characteristics of the invention are described more concretely with reference to the following Examples, but the invention should not be limitatively interpreted by the Examples.

### Example 1

On the smoothness surface of a PEN film having a thickness of 100 µm (manufactured by Teijin DuPont Films Japan Ltd.), SiO (manufactured by OSAKA Titanium Technologies Co.,Ltd.) was deposited to form a deposited film using a deposition apparatus applicable to plasma-assist method by EB (electron beam) and ion gun system (manufactured by Shincron Co., Ltd., ACE1350IAD). The condition was that the ion-assisted electric voltage was 900 V, oxygen gas flow rate was 50 sccm, and argon gas flow rate was 8 sccm. Thereby, a deposited film A-1 having a thin film of silicon oxide on the surface thereof was formed. The film formation rate was 5 nm/sec and the thickness of the inorganic layer was 50 nm. The surface roughness (Ra) of the deposited film was 1.57 nm. The water vapor permeability of the deposited film was 0.05 g/m²·day.

Next, dry-lamination was carried out so that the deposited sides of the deposited films A-1 face to each other. As an adhesive, SEIKABOND manufactured by Dainichiseika Color & Chemicals Mfg.Co., Ltd., of which the main compound was E-372 and the curing agent was C-76-2.0, was used. The main compound and the curing agent was weighted and mixed at a ratio of 17:2 by weight, and diluted with ethyl acetate to decuple dilution. The obtained uniform coating liquid was coated by spin-coating method. For varying the concentration of the adhesive, ethyl acetate was used as dilution solvent. After the solvent was dried for 5 minutes at 90°C, the film was passed through a pair of nip rolls which were heated at 70°C to thereby be laminated, and subjected to aging for 48 hours at 40°C. Thus, the gas barrier composite A-1 was obtained. The thickness of the adhesive layer was determined as an average value of ten measurement points which were randomly chosen in the sample after the aging by a micro meter.

### Example 2

The gas barrier composites A-2 to A-5 were formed according to the same method in that in Example 1, except that the thickness of the adhesive layer was changed by changing dilution magnification of the diluted solvent.

### Comparative Example 1

A deposited film B-1 was formed according to the same method as that in Examples 1 and 2, except that the substrate film was replaced with a PET film having a thickness of 100 µm (manufactured by Toray Industries, Inc.). The deposited film had a surface roughness of 61.7 nm.

Gas barrier composites B-2 to B-5 were formed according to the same method as that in Example 2, except that the deposited film A-1 was replaced with the deposited film B-1.

### Example 3

A coating solution was prepared by solving 9 g of tripropylene glycol diacrylate (TPGDA, manufactured by Daicel-Cytec Company

Ltd.) as a photo polymerizable acrylate and 0.1 g of a photopolymerization initiator (manufactured by Chiba, Irgacure 907) into 190 g of methyl ethyl ketone. The coating solution was coated on a surface of a PET film having a thickness of 100 µm (manufactured by Toray Industries, Inc.) using a wire bar, irradiated with ultraviolet having illuminance of 350 mW/cm² at irradiance level of 500 mJ/cm² under nitrogen purge at the oxygen concentration of 0.1% or less, using an air cooled metal halide lamp having 160 W/cm (manufactured by EYE GRAPHICS Co., Ltd.), to thereby form an organic layer. The thickness of the organic layer was about 500 nm. On its surface, an inorganic layer was formed according to the same method as that in Example 1, to thereby obtain a deposited film C-1. The surface roughness (Ra) was 0.48 nm.

Gas barrier composites C-2 to C-5 were formed according to the same method as that in Examples 1 and 2, except that the deposited film A-1 was replaced with the deposited film C-1.

### Example 4

Gas barrier composites D-1 to D-5 were formed according to the same method as that in Example 3, except that the adhesive was replaced with an adhesive, SEIKABOND manufactured by Dainichiseika Color & Chemicals Mfg.Co., Ltd., of which the main compound was A-159 and the curing agent was C-89(F).

### Comparative Example 2

A gas barrier composite E-1 was formed according to the same method as that in Example 3, except that two of the deposited films C-1 were laminated so that the deposited surface of one of the deposited film C-1 and the undeposited surface of the other deposited film C-1 were faced to each other, and the thickness of the adhesive layer was adjusted to be 1.88 µm.

### Comparative Example 3

Gas barrier composite F-1 was formed according to the same method as that in Example 3, except that the adhesive was replaced with a solution comprising an amorphous polyester resin (manufactured by Toyobo Co., Ltd., byron 600) in the concentration of 7. 5% by weight in a polypropylene glycol monomethyl ether acetate (PEGMEA).

### Comparative Example 4

A gas barrier composite G-1 was formed according to the same method as that in Example 1, except that the deposition film was replaced with a deposition film G-1 which was formed by forming a film of metal aluminium having a thickness of 50 nm according to a vacuum deposition method on the smoothness surface of a PEN film having a thickness of 100 µm (manufactured by Teijin DuPont Films Japan Ltd.). The deposition film had a surface roughness (Ra) of 1.85 nm and had water vapor permeability of 0.95 g/m²·day.

### Comparative Example 5

Deposited films H-1 to H-5 were formed according to the same method as that in Example 3, except that methyl ethyl ketone was replaced with the equal amount of propylene glycol-1-monomethyl ether-2-acetate (PEGMEA). The deposited films each have a surface roughness (Ra) of 4.15 nm and each have water vapor permeability of 0.05 g/m²·day.

Further, gas barrier composites H-1 to H-5 were formed according to the same method as that in Example 3, except for using the deposited films H-1 to H-5.

### <Surface Roughness (Ra)>

Using a scanning probe microscope SPI3700 manufactured by Seiko Instruments Inc. as an atom force microscope (AFM), surface of the above samples was measured according to the following condition;
Mode : dynamic force mode
measured area : 10×10 µm square
scan rate : 1 Hz
direction : x-y direction
division : 512×256
cantilever : :SI-DF-20(Si, f=126 kHz, c=16 N/m).

The obtained photographics was subject to inclination auto-correction treatment, and then, subject to three dimensional roughness analysis, to thereby determine a center line average roughness (Ra(nm)). At this time, the cantilever used for the measurement was frictionless and clean.

### <Water Vapor Permeability>

Using PERMATRAN-W3/31 manufactured by MOCON as a water vapor permeability apparatus, water vapor permeability was measured at 40°C and 90% relative humidity. The water vapor permeability of 0.01 g/m²/day or less, which is below the detection limit, was measured by the following method. On a sample film, metal Ca was directly deposited so as to have a thickness of 40 nm. The film was sealed wit a grass substrate and a commercial available sealing member used for an organic EL device so that the deposited Ca side becomes inside. Thereby, measurement sample was obtained. The measurement sample was placed under the above condition for temperature and humidity, and the water vapor permeability was measured and evaluated on the basis of change of optical concentration of metal Ca on the sample film while the condition for temperature and humidity was maintained. The optical concentration of metal Ca was based on reduction of metallic luster of the metal Ca by hydroxylation or oxidation.

### <Measurement of Adhesive Force>

Strength of the sample as adhesive force was measured according to T type peeling method at a tensile rate of 300 mm/min at the sample wide of 15 mm using a universal tensile testing machine manufactured by Shimadzu Corporation. In addition, the sample which was cut into A5 size was placed at 105 ° C for 168 hours in a pressure cooker testing machine (manufactured by Yamato Scientific Co., Ltd., an acceleration evaluating apparatus, carried out by pressured steam). The edge was sealed with aluminium sheet having a thickness of 2 mm. Next, the strength was measured and evaluated.

**[Table 1]**

| (1) | (2) Ra [nm] | (3) Thickness | (4) Adhesive | (5) WVP | (6) Adhesion Force | | Remark |
|---|---|---|---|---|---|---|---|
| | | | | | (6-1) Fresh | (6-2) Over Times | |
| A-1 | 1.57 | 0.08 | Ester type | 0.005 | 3.8 | 2.9 | Example |
| A-2 | 1.57 | 0.65 | Ester type | 0.008 | 4.5 | 3.6 | Example |
| A-3 | 1.57 | 1.82 | Ester type | 0.011 | 4.9 | 4.0 | Example |
| A-4 | 1.57 | 3.23 | Ester type | 0.032 | 5.2 | 4.3 | Example |
| A-5 | 1.57 | 5.25 | Ester type | 0.060 | 6.1 | 4.9 | Example |
| B-1 | 61.7 | 0.09 | Ester type | 0.023 | 3.5 | 2.1 | Comp. Exam. |
| B-2 | 61.7 | 0.73 | Ester type | 0.021 | 3.8 | 2.5 | Comp. Exam. |
| B-3 | 61.7 | 1.75 | Ester type | 0.040 | 4.1 | 3.0 | Comp. Exam. |
| B-4 | 61.7 | 3.12 | Ester type | 0.069 | 4.8 | 3.5 | Comp. Exam. |
| B-5 | 61.7 | 5.58 | Ester type | 0.088 | 5.5 | 3.9 | Comp. Exam. |
| C-1 | 0.48 | 0.08 | Ester type | 0.003 | 3.9 | 2.8 | Example |
| C-2 | 0.48 | 0.66 | Ester type | 0.003 | 4.4 | 3.4 | Example |
| C-3 | 0.48 | 1.85 | Ester type | 0.004 | 4.8 | 4.0 | Examples |
| C-4 | 0.48 | 3.41 | Ester type | 0.007 | 5.3 | 4.5 | Example |
| C-5 | 0.48 | 5.10 | Ester type | 0.009 | 5.2 | 5.1 | Example |
| D-1 | 0.48 | 0.09 | Ether type | 0.002 | 4.0 | 3.0 | Example |
| D-2 | 0.48 | 0.72 | Ether type | 0.002 | 4.3 | 3.7 | Example |
| D-3 | 0.48 | 1.81 | Ether type | 0.003 | 4.8 | 4.5 | Example |
| D-4 | 0.48 | 3.68 | Ether type | 0.005 | 5.1 | 4.8 | Example |
| D-5 | 0.48 | 5.45 | Ether type | 0.008 | 5.9 | 5.5 | Examples |
| E-1 | 0.48 | 1.88 | Ester type | 0.101 | 5.0 | 0.6 | Comp. Exam. |
| F-1 | 0.48 | 1.82 | Polyester Adhesive | 0.029 | 3.7 | Peeled off | Comp. Exam. |
| G-1 | 1.85 | 0.08 | Ester type | 0.550 | 4.5 | Peeled off | Comp. Exam. |
| H-1 | 4.15 | 0.09 | Ester type | 0.011 | 3.4 | 2.5 | Comp. Exam. |
| H-2 | 4.15 | 0.69 | Ester type | 0.010 | 3.6 | 2.6 | Comp. Exam. |
| H-3 | 4.15 | 1.78 | Ester type | 0.019 | 4.0 | 2.9 | Comp. Exam. |
| H-4 | 4.15 | 3.45 | Ester type | 0.042 | 4.8 | 3.5 | Comp. Exam. |
| H-5 | 4.15 | 5.36 | Ester type | 0.064 | 5.6 | 4.0 | Comp. Exam. |

In the table 1, Column (1) stands for Sample name, Column (2) stands for Surface Roughness (Ra) of Inorganic Layer [nm], Column (3) stands for Thickness of Adhesive Layer [µm], Column (4) stands for kind of an adhesive for use herein, Column (5) stands for Water vapor permeability [g/m²·day], and Column (6) stands for Adhesion force [N/15mm].

### Example 5

For the purpose of confirming the effect to inhibit water vapor from penetrating from edge of the gas barrier composites D-1 to D-5 (sideways penetration of gas barrier composite), the edges of the gas barrier composites D-1 to D-5 each were fully sealed with a metal aluminium sheet having a thickness of 1 mm, and the water vapor permeability was evaluated. It was found that the penetration of water vapor from the edge of a film was inhibited when its adhesive layer has a thinner thickness.

**[Table 2]**

| Sample | Thickness of Adhesive Layer [µm] | Water Vapor Permeability [g/m²·day] | | Difference of the WAPs [g/m²·day] |
|---|---|---|---|---|
| | | The edge was not sealed | The edge was sealed | |
| D-1 | 0.09 | 0.002 | 0.0009 | 0.0011 |
| D-2 | 0.72 | 0.002 | 0.001 | 0.001 |
| D-3 | 1.81 | 0.003 | 0.002 | 0.001 |
| D-4 | 3.68 | 0.005 | 0.004 | 0.001 |
| D-5 | 5.45 | 0.008 | 0.008 | - |

### Formation of Back Sheet for Solar Cell Module

A back sheet for a solar cell module was formed by laminating Lumirror X10S (having a thickness of 50µm, manufactured by TORAY) on one surface of the gas barrier composite formed in Example 3 using the same adhesive as that in Example 1, and laminating Lumirror E20 (having a thickness of 50µm, manufactured by TORAY) on the other surface of the gas barrier composite using the same adhesive as that in Example 1.

### Example 6

### Formation of Solar Cell Module

Using the back sheet for a solar cell module as formed in the above, solar cell modules each were manufactured. As filler for use in a solar cell module, standard cure type of ethylene-vinyl acetate copolymer was used. On the surface of a strengthen glass having an area of 10 cm square , amorphous series silicone cell for a solar cell was sandwiched by ethylene-vinyl acetate copolymer films having a thickness of 450 µm, and then, on the surface thereof, the above back sheet for a solar cell modules each were deposited to form a solar cell module. The solar cell module was set up by vacuuming it at 150°C for 3 minutes and pressuring it for 9 minutes. The solar cell module as formed by the method worked properly and kept good electric generating power property even if used at 85°C and 85% RH.

### INDUSTRIAL APPLICABILITY

The invention makes it possible to provide a back sheet for a solar cell module which attains the desired barrier property and is excellent in adhesion between the layers. Especially, since the method of the invention can be formed without using aluminium foil, the back sheet of the invention can be used for a back sheet having insulating properties.

Further, the back sheet for a solar cell module of the invention has no limitation concerning application to back sheet as that in J.Appl. Polym. Sci. Vol. 106, 3534-3542 (2007), such as cost, continuous productivity, adhesiveness and durability.

In addition, the back sheet for a solar cell module is stable under heat and humidity over times. Since solar cells are used in outside for long years, such stability is much important.

## Claims

1. A gas barrier composite comprising two gas barrier films and an adhesive layer between the gas barrier films, wherein the gas barrier films each have a substrate film and a barrier layer on the substrate film, the barrier layers of the respective gas barrier films each comprising an inorganic layer and facing each other through the adhesive layer,
**characterized in that**
the inorganic layers of the barrier layers are substantively composed of an inorganic oxide, an inorganic nitride or a mixture thereof;
the barrier layers each have an outermost layer having a surface roughness (Ra) of 0.1 to 3 nm;
and the adhesive layer is obtainable by curing a two-liquid type polyurethane adhesive.

2. The gas barrier composite according to Claim 1, wherein the adhesive layer has a thickness of from not less than 0.1 µm to less than 2 µm.

3. The gas barrier composite according to Claim 1 or 2, wherein the adhesive layer is adjacent to an inorganic layer of at least one of the gas barrier films.

4. The gas barrier composite according to Claim 1 or 2, wherein the adhesive layer is adjacent to an inorganic layer of at least one of the gas barrier films; and at least one of the gas barrier films comprises an undercoat layer between the substrate film and the inorganic layer.

5. The gas barrier composite according to any one of Claims 1 to 4, wherein the two-liquid type polyurethane adhesive comprises an isocyanate compound comprising two or more functional groups and a polyurethane polyol.

6. The gas barrier composite according to any one of Claims 1 to 5, wherein the inorganic layers each are obtainable by a deposition method.

7. The gas barrier composite according to any one of Claims 1 to 6, wherein the barrier layers each comprise at least two inorganic layers and at least two organic layers laminated alternately.

8. The gas barrier composite according to any one of Claims 1 to 7, wherein the substrate films each have a surface roughness (Ra) of 0.1 to 1.0 nm.

9. A back sheet for a solar cell module comprising the gas barrier composite of any one of Claims 1 to 8.

10. The back sheet for a solar cell module according to Claim 9, wherein the two-liquid type polyurethane adhesive has a laminate strength of 1 N/15 mm or more and does not cause delamination after being placed at 105 °C at a relative humidity of 100% for 24 hours.

11. The back sheet for a solar cell module according to Claim 9 or 10, wherein the two-liquid type polyurethane adhesive comprises an isocyanate compound comprising two or more functional groups and a polyurethane polyol.

12. The back sheet for a solar cell module according to any one of Claims 9 to 11, wherein the inorganic layers each are obtainable by a deposition method.

13. The back sheet for a solar cell module according to any one of Claims 9 to 12, wherein the inorganic layers each are substantively composed of silicon oxide, aluminium oxide or a mixture thereof.

14. The back sheet for a solar cell module according to any one of Claims 9 to 13, wherein the barrier layers each have an outermost layer having a surface roughness (Ra) of 0.1 to 1.0 nm.

15. A solar cell module comprising a back sheet for a solar cell module comprising the gas barrier composite of any one of Claims 1 to 8.

## Patentansprüche

1. Gassperrkomposit, umfassend zwei Gassperrfolien und eine Adhäsivschicht zwischen den Gassperrfolien, worin die Gassperrfolien jeweils eine Substratfolie und eine Barrierenschicht auf der Substratfolie aufweisen, wobei die Barrierenschichten der jeweiligen Gassperrfolien jeweils eine anorganische Schicht umfassen und einander durch die Adhäsivschicht gegenüber liegen,
**dadurch gekennzeichnet, dass**
die anorganischen Schichten der Barriereschichten substantiell zusammengesetzt sind aus einem anorganischen Oxid, einem anorganischen Nitrid oder einer Mischung hiervon;
die Barrierenschichten jeweils eine äußerste Schicht mit einer Oberflächenrauigkeit (Ra) von 0,1 bis 3 nm aufweisen;
und die Adhäsivschicht erhältlich ist durch Härten eines Polyurethan-Adhäsivs vom Zwei-Flüssigkeiten-Typ.

2. Gassperrkomposit gemäß Anspruch 1, worin die Adhäsivschicht eine Dicke von nicht kleiner als 0,1 µm bis kleiner als 2 µm aufweist.

3. Gassperrkomposit gemäß Anspruch 1 oder 2, worin die Adhäsivschicht an eine anorganische Schicht von mindestens einer der Gassperrfolien angrenzt.

4. Gassperrkomposit gemäß Anspruch 1 oder 2, worin die Adhäsivschicht an eine anorganische Schicht von mindestens einer der Gassperrfolien angrenzt; und mindestens eine der Gassperrfolien eine Unterzugsschicht zwischen der Substratfolie und der anorganischen Schicht umfasst.

5. Gassperrkomposit gemäß irgendeinem der Ansprüche 1 bis 4, worin das Polyurethan-Adhäsiv vom Zwei-Flüssigkeiten-Typ eine Isocyanatverbindung, die zwei oder mehr funktionelle Gruppen umfasst, und ein Polyurethan-Polyol umfasst.

6. Gassperrkomposit gemäß irgendeinem der Ansprüche 1 bis 5, worin die anorganischen Schichten jeweils durch ein Abscheidungsverfahren erhältlich sind.

7. Gassperrkomposit gemäß irgendeinem der Ansprüche 1 bis 6, worin die Barriereschichten jeweils mindestens zwei anorganische Schichten und mindestens zwei organische Schichten, die abwechselnd laminiert sind, umfassen.

8. Gassperrkomposit gemäß irgendeinem der Ansprüche 1 bis 7, worin die Substratfolien jeweils eine Oberflächenrauigkeit (Ra) von 0,1 bis 1,0 nm aufweisen.

9. Rückblatt/-folie für ein Solarzellenmodul, umfassend das Gassperrkomposit gemäß irgendeinem der Ansprüche 1 bis 8.

10. Rückblatt/-folie für ein Solarzellenmodul gemäß Anspruch 9, worin das Polyurethan-Adhäsiv vom Zwei-Flüssigkeiten-Typ eine Laminatfestigkeit von 1 N/15 mm oder größer aufweist und keine Delaminierung verursacht, nachdem es bei 105°C bei einer relativen Luftfeuchtigkeit von 100 % für 24 Stunden gelagert worden ist.

11. Rückblatt/-folie für ein Solarzellenmodul gemäß Anspruch 9 oder 10, worin das Polyurethan-Adhäsiv vom Zwei-Flüssigkeiten-Typ eine Isocyanatverbindung, die zwei oder mehr funktionelle Gruppen umfasst, und ein Polyurethan-Polyol umfasst.

12. Rückblatt/-folie für ein Solarzellenmodul gemäß irgendeinem der Ansprüche 9 bis 11, worin die anorganischen Schicht jeweils durch ein Abscheidungsverfahren erhältlich sind.

13. Rückblatt/-folie für ein Solarzellenmodul gemäß irgendeinem der Ansprüche 9 bis 12, worin die anorganischen Schichten jeweils substantiell zusammengesetzt sind aus Siliziumoxid, Aluminiumoxid oder einer Mischung hiervon.

14. Rückblatt/-folie für ein Solarzellenmodul gemäß irgendeinem der Ansprüche 9 bis 13, worin die Barrierenschichten jeweils eine äußerste Schicht mit einer Oberflächenrauheit (Ra) von 0,1 bis 1,0 nm aufweisen.

15. Solarzellenmodul, umfassend ein Rückblatt/-folie für ein Solarzellenmodul, das das Gassperrkomposit gemäß gemäß irgendeinem der Ansprüche 1 bis 8 umfasst.

## Revendications

1. Composite de barrière au gaz comprenant deux films de barrière au gaz et une couche adhésive entre les films de barrière au gaz, dans lequel les films de barrière au gaz présentent chacun un film de substrat et une couche de barrière sur le film de substrat, les couches de barrière des films de barrière au gaz respectifs comprenant chacune une couche inorganique et étant opposées l'une à l'autre à travers la couche adhésive,
**caractérisé en ce que**
les couches inorganiques des couches de barrière sont essentiellement constituées d'un oxyde inorganique, d'un nitrure inorganique ou d'un mélange de ceux-ci ;
les couches de barrière présentent chacune une couche extérieure présentant une rugosité de surface (Ra) de 0,1 à 3 nm ;
et la couche adhésive peut être obtenue par durcissement d'un adhésif de polyuréthane de type à deux liquides.

2. Composite de barrière au gaz selon la revendication 1, dans lequel la couche adhésive présente une épaisseur d'au moins 0,1 µm à moins de 2 µm.

3. Composite de barrière au gaz selon la revendication 1 ou 2, dans lequel la couche adhésive est adjacente à une couche inorganique d'au moins un des films de barrière au gaz.

4. Composite de barrière au gaz selon la revendication 1 ou 2, dans lequel la couche adhésive est adjacente à une couche inorganique d'au moins un des films de barrière au gaz ; et au moins un des films de barrière au gaz comprend une couche de revêtement inférieur entre le film de substrat et la couche inorganique.

5. Composite de barrière au gaz selon l'une quelconque des revendications 1 à 4, dans lequel l'adhésif de polyuréthane de type à deux liquides comprend un composé d'isocyanate comprenant deux ou plusieurs groupes fonctionnels et un polyuréthane polyol.

6. Composite de barrière au gaz selon l'une quelconque des revendications 1 à 5, dans lequel les couches inorganiques peuvent chacune être obtenues par un procédé de dépôt.

7. Composite de barrière au gaz selon l'une quelconque des revendications 1 à 6, dans lequel les couches de barrière comprennent chacune au moins deux couches inorganiques et au moins deux couches organiques stratifiées de manière alternée.

8. Composite de barrière au gaz selon l'une quelconque des revendications 1 à 7, dans lequel les films de substrat présentent chacun une rugosité de surface (Ra) de 0,1 à 1,0 nm.

9. Feuille de support pour un module de cellule photovoltaïque comprenant le composite de barrière au gaz selon l'une quelconque des revendications 1 à 8.

10. Feuille de support pour un module de cellule photovoltaïque selon la revendication 9, dans laquelle l'adhésif de polyuréthane de type à deux liquides présente une résistance de stratifié de 1 N/15 mm ou supérieure et n'occasionne pas une déstratification après avoir été placé à 105°C à une humidité relative de 100 % pendant 24 heures.

11. Feuille de support pour un module de cellule photovoltaïque selon la revendication 9 ou 10, dans laquelle l'adhésif de polyuréthane de type à deux liquides comprend un composé d'isocyanate comprenant deux groupes fonctionnels ou plus et un polyuréthane/polyol.

12. Feuille de support pour un module de cellule photovoltaïque selon l'une quelconque des revendications 9 à 11, dans laquelle les couches inorganiques peuvent chacune être obtenues par un procédé de dépôt.

13. Feuille de support pour un module de cellule photovoltaïque selon l'une quelconque des revendications 9 à 12, dans laquelle les couches inorganiques sont chacune essentiellement constituées d'oxyde de silicium, d'oxyde d'aluminium ou d'un mélange de ceux-ci.

14. Feuille de support pour un module de cellule photovoltaïque selon l'une quelconque des revendications 9 à 13, dans laquelle les couches barrière présentent chacune une couche extérieure présentant une rugosité de surface (Ra) de 0,1 à 1,0 nm.

15. Module de cellule photovoltaïque comprenant une feuille de support pour un module de cellule photovoltaïque comprenant le composite de barrière au gaz selon l'une quelconque des revendications 1 à 8.
